# EUROPEAN PATENT APPLICATION

(11) **EP 3 702 049 A1**
(43) Date of publication of application: **02.09.2020**
(21) Application number: 18871697.1
(22) Date of filing: 11.10.2018
(51) Int. Cl.: B05D 3/10, B05D 1/26, B05D 7/14, C09D 11/30, C23C 22/26, C23C 22/52, H05K 3/06, H05K 3/26

(54) **METHOD FOR PRODUCING FILM FORMATION SUBSTRATE, FILM FORMATION SUBSTRATE, AND SURFACE TREATMENT AGENT**

(30) Priority: 23.10.2017 JP 2017204817
(71) Applicant: MEC COMPANY., LTD., Amagasaki-shi, Hyogo 660-0822 (JP)
(72) Inventor: NISIE Kenji, Amagasaki-shi Hyogo 660-0822 (JP); OKA Yuki, Amagasaki-shi Hyogo 660-0822 (JP); ICHIHASHI Tomoko, Amagasaki-shi Hyogo 660-0822 (JP); FUJII Takuto, Amagasaki-shi Hyogo 660-0822 (JP)
(74) Representative: dompatent von Kreisler Selting Werner - Partnerschaft von Patent- und Rechtsanwälten mbB
(86) International application number: PCT/JP2018/038011
(87) International publication number: WO 2019/082681

(57) **Abstract**

An object is to provide, for example, a method for manufacturing a film-forming substrate that can sufficiently improve both bleeding of a resin composition and adhesion between the resin composition and a metal substrate surface. For example, provided is a method for manufacturing a film-forming substrate having a film of a resin composition formed on a metal substrate surface, the method including: an etching step of etching a metal substrate surface with a microetching agent; a surface treatment step of bringing the etched metal substrate surface into contact with a surface treatment agent to perform a surface treatment such that a contact angle of water on the surface is 50° or more and 150° or less; and a film forming step of forming a film of a resin composition on the surface-treated metal substrate surface by an inkjet method.

## Description

### Technical Field

The present invention relates to a method for manufacturing a film-forming substrate, a film-forming substrate, and a surface treatment agent.

### Background Art

A film-forming substrate having a film of a resin composition such as a solder resist or an etching resist on a metal substrate surface is used, for example, as a printed wiring board coated with a solder resist except for a copper opening used for electrical connection by soldering. Such a film-forming substrate is generally manufactured by applying a resin composition to a desired position on a metal substrate surface by printing using a screen plate, a photo method of performing exposure and development, or the like. However, in recent years, attention has been paid to a method of forming a film by drawing a resin composition by an inkjet method.

The inkjet method does not need a plate or a photomask, has a small number of steps, and can easily form a film only on a necessary portion advantageously. Meanwhile, a resin composition such as a solder resist or an etching resist bleeds on a metal substrate at an end of a print applied portion disadvantageously, which has not been regarded as a problem in related art. That is, bleeding needs to be reduced. As a technique for reducing such bleeding on a metal substrate, for example, as described in Patent Literatures 1 to 3, a surface treatment for bringing a metal substrate surface into contact with a surface treatment agent containing a surfactant or the like is performed in order to adjust wettability of the metal substrate surface.

Meanwhile, when the resin composition is applied onto the metal substrate, it is required to improve adhesion between the metal substrate surface and the resin composition. In order to improve the adhesion between the metal substrate surface and the resin composition, for example, as described in Patent Literatures 2 and 3, it is known to perform a treatment of forming unevenness on a metal surface by buffing or scrubbing to form a rough surface (roughening treatment) before a surface treatment.

However, it is difficult to sufficiently improve the adhesion only by the roughening treatment. Particularly, when a film of the resin composition is formed according to a fine pattern, an effect of improving the adhesion is insufficient. Furthermore, the resin composition is more likely to bleed by roughening the metal surface disadvantageously.

Therefore, it is required to simultaneously improve bleeding of the resin composition and the adhesion between the resin composition and the metal substrate surface in the film-forming substrate by an inkjet method.

### Documents for prior art

### Patent Documents

Patent Document 1: JP 2015-192963 A
Patent Document 2: WO 2016/111035 A
Patent Document 3: WO 2016/111036 A

### Summary of Invention

### Problem to be Solved by the Invention

The present invention has been achieved in view of the problems of related art as described above. An object of the present invention is to provide a method for manufacturing a film-forming substrate, a film-forming substrate, and a surface treatment agent, capable of sufficiently improving both bleeding of a resin composition and adhesion between the resin composition and a metal substrate surface when a film of the resin composition is formed on the metal substrate surface by an inkjet method.

### Means for Solving the Problems

A method for manufacturing a film-forming substrate having a film of a resin composition formed on a metal substrate surface according to an embodiment of the present invention includes: an etching step of etching a metal substrate surface with a microetching agent; a surface treatment step of bringing the etched metal substrate surface into contact with a surface treatment agent to perform a surface treatment such that a contact angle of water on the metal substrate surface is 50° or more and 150° or less; and a film forming step of forming a film of a resin composition on the surface-treated metal substrate surface by an inkjet method.

A method for manufacturing a film-forming substrate having a film of a resin composition formed on a metal substrate surface according to another embodiment of the present invention includes: an etching step of etching a metal substrate surface with a microetching agent; a surface treatment step of bringing the etched metal substrate surface into contact with a surface treatment agent to perform a surface treatment such that a contact angle of a solder resist on the metal substrate surface is 10° or more and 120° or less; and a film forming step of forming a film of a resin composition on the surface-treated metal substrate surface by an inkjet method.

In the etching step, the metal substrate surface may be etched so as to have a surface roughness (Ra) of 0.1 µm or more and 0.8 µm or less.

A method for manufacturing a film-forming substrate having a film of a resin composition formed on a metal substrate surface according to another embodiment of the present invention includes: a roughening step of mechanically roughening a metal substrate surface; a surface treatment step of bringing the roughened metal substrate surface into contact with a surface treatment agent to perform a surface treatment such that a contact angle of water on the metal substrate surface is 50° or more and 150° or less; and a film forming step of forming a film of a resin composition on the surface-treated metal substrate surface by an inkjet method.

Furthermore, a method for manufacturing a film-forming substrate having a film of a resin composition formed on a metal substrate surface according to another embodiment of the present invention includes: a roughening step of mechanically roughening a metal substrate surface; a surface treatment step of bringing the roughened metal substrate surface into contact with a surface treatment agent to perform a surface treatment such that a contact angle of a solder resist on the metal substrate surface is 10° or more and 120° or less; and a film forming step of forming a film of a resin composition on the surface-treated metal substrate surface by an inkjet method.

In the surface treatment step, a surface treatment agent containing at least one selected from the group consisting of alkylamines in each of which an alkyl group has 6 to 18 carbon atoms and salts thereof in an amount of 0.001% by mass or more and 1% by mass or less may be brought into contact.

The alkylamine in which an alkyl group has 6 to 18 carbon atoms or a salt thereof may be at least one selected from the group consisting of hexylamine, octadecylamine, dodecylamine, tetradecylamine, and octylamine.

The surface treatment agent may have pH of 4.0 or more and 11.5 or less.

In a film-forming substrate having a film of a resin composition formed on a metal substrate surface according to an embodiment of the present invention, a contact angle of water on the metal substrate surface is 50° or more and 150° or less, and a surface roughness (Ra) thereof is 0.1 µm or more and 0.8 µm or less.

In a film-forming substrate having a film of a resin composition formed on a metal substrate surface according to another embodiment of the present invention, a contact angle on the metal substrate surface with respect to a solder resist is 10° or more and 120° or less, and a surface roughness (Ra) thereof is 0.1 µm or more and 0.8 µm or less.

A surface treatment agent for treating a metal substrate surface before formation of a resin composition film according to an embodiment of the present invention is a metal substrate surface treatment agent for forming a film of a resin composition on a surface by an inkjet method. The surface treatment agent contains at least one selected from the group consisting of alkylamines in each of which an alkyl group has 6 to 18 carbon atoms and salts thereof in an amount of 0.001% by mass or more and 1% by mass or less.

In the surface treatment agent according to an embodiment of the present invention, the alkylamine in which an alkyl group has 6 to 18 carbon atoms or a salt thereof may be at least one selected from the group consisting of hexylamine, octadecylamine, dodecylamine, tetradecylamine, and octylamine.

Alternatively, the surface treatment agent may have pH of 4.0 or more and 11.5 or less.

### Effects of Invention

The present invention can provide a method for manufacturing a film-forming substrate, a film-forming substrate, and a surface treatment agent, capable of sufficiently improving both bleeding of a resin composition and adhesion between the resin composition and a metal substrate surface.

### Brief Description of Drawings

Fig. 1 is a graph illustrating a relationship between a bleeding width of a test substrate and a contact angle thereof in each of Examples and Comparative Examples.
Fig. 2 is a graph illustrating a relationship between a bleeding width of a test substrate and a peel strength thereof in each of Examples and Comparative Examples.
Fig. 3 is a graph illustrating a relationship between a peel strength and a surface roughness.

### Description of Embodiments

Hereinafter, a method for manufacturing a film-forming substrate (hereinafter, also simply referred to as a manufacturing method), a film-forming substrate, and a surface treatment agent according to an embodiment of the present invention will be described.

### (First embodiment: method for manufacturing film-forming substrate)

A method for manufacturing a film-forming substrate according to the present embodiment is a method for manufacturing a film-forming substrate having a film of a resin composition formed on a metal substrate surface, the method including: an etching step of etching a metal substrate surface with a microetching agent; a surface treatment step of bringing the etched metal substrate surface into contact with a surface treatment agent to perform a surface treatment such that a contact angle of water on the metal substrate surface is 50° or more and 150° or less; and a film forming step of forming a film of a resin composition on the surface-treated metal substrate surface by an inkjet method.

### <Film-forming substrate>

A film-forming substrate manufactured by the manufacturing method of the present embodiment is not particularly limited as long as being a substrate having a film of a resin composition formed on a metal substrate surface by an inkjet method. Examples thereof include a circuit board such as a printed wiring board, various other electronic/electric devices, medical devices, devices mounted on vehicles, parts for automobiles, and parts for marine devices.

A metal constituting the metal substrate is not particularly limited. However, examples thereof include copper, tin, stainless steel, aluminum, nickel, titanium, and alloys thereof.

The manufacturing method of the present embodiment is particularly suitable, for example, for manufacturing a circuit board in which a solder resist is formed as a film on a portion other than a conductor made of copper or a metal containing copper such as a copper alloy (hereinafter, also simply referred to as copper) on a metal substrate containing the conductor.

### <Etching step>

The manufacturing method of the present embodiment includes an etching step of etching a metal substrate surface with a microetching agent.

The microetching agent used in the etching step refers to an etching agent for slightly etching a metal surface by bringing the microetching agent into contact with the metal surface to form fine unevenness (performing microetching) on the metal surface.

The microetching agent used in the present embodiment is not particularly limited as long as being able to microetch a metal constituting the metal substrate. For example, when the metal substrate is made of copper, a known copper microetching agent is used. Specific examples thereof include an organic acid-based etching agent, a sulfuric acid-hydrogen peroxide-based etching agent, and a persulfate-based etching agent.

Preferred examples of the microetching agent include an organic acid-based microetching agent. Examples thereof include a commercially available microetching agent such as an aqueous solution containing an organic acid, a cupric ion, a halide ion, an amino group-containing compound, or a polymer.

In the etching step, a microetching agent is brought into contact with the metal substrate surface, and the metal substrate surface is etched to form fine unevenness on the surface.

The formation of such fine unevenness improves adhesion between the metal substrate surface and the resin composition.

Treatment conditions in the etching step, that is, treatment time, temperature at the time of a treatment with a microetching agent, and a treatment method such as spraying or immersion can be appropriately adjusted.

In the etching step, the metal substrate surface is treated, for example, so as to have a surface roughness (Ra) of 0.1 µm or more and 0.8 µm or less, preferably 0.2 µm or more and 0.7 µm or less, more preferably 0.3 µm or more and 0.7 µm or less. By performing a treatment such that the surface roughness falls within such a range, adhesion between the metal substrate surface and the resin composition is improved after a subsequent surface treatment step, and bleeding of the resin composition can be suppressed.

Note that the surface roughness (Ra) in the present embodiment refers to an arithmetic average roughness measured according to JIS B 0601 (2013).

The etching amount by a weight method in the etching step is preferably adjusted appropriately so as to achieve the above surface roughness, and for example, is about 0.5 µm or more and 2.0 µm or less, and preferably about 0.7 µm or more and 1.5 µm or less.

By setting the etching amount within the above range, it is easy to achieve an appropriate surface roughness, and therefore, it is easy to improve the adhesion between the metal substrate surface and the resin composition after a subsequent surface treatment step.

### <Surface treatment step>

The manufacturing method of the present embodiment includes a surface treatment step of bringing a surface treatment agent into contact with the etched metal substrate surface and performing a surface treatment such that a contact angle of water on the metal surface is 50° or more and 150° or less.

In the surface treatment step of the present embodiment, a treatment is performed using a surface treatment agent capable of adjusting a contact angle on the microetched metal substrate surface.

The surface treatment agent that can be used in the present embodiment is not particularly limited as long as being a surface treatment agent that can adjust a contact angle on the metal substrate surface within such a range as described above. However, when the surface treatment agent of the present embodiment as described later is used, an effect of the manufacturing method of the present embodiment can be enhanced.

Note that the contact angle in the present embodiment refers to a value measured by a sessile drop method described in JIS R3257 "Testing method of wettability of glass substrate".

Examples of an active component of the surface treatment agent include an anionic surfactant, a nonionic surfactant, a cationic surfactant, an amphoteric surfactant solution, and a solution containing an alkylamine compound as an active component.

Examples of an alkylamine constituting the alkylamine compound include methylamine, ethylamine, propylamine, butylamine, pentylamine, hexylamine, heptylamine, octylamine, nonylamine, decylamine, undecylamine, dodecylamine, tridecylamine, tetradecylamine, pentadecylamine, hexadecylamine, heptadecylamine, and octadecylamine. Among these compounds, a particular example of the alkylamine is an alkylamine in which an alkyl group constituting an alkylamine has 6 to 18 carbon atoms, such as hexylamine, heptylamine, octylamine, nonylamine, decylamine, undecylamine, dodecylamine, tridecylamine, tetradecylamine, pentadecylamine, hexadecylamine, heptadecylamine, or octadecylamine.

Examples of the alkylamine compound include the above alkylamines and salts thereof such as inorganic acid salts and organic acid salts.

The active component of the surface treatment agent may be used singly or in combination of two or more types thereof.

As the alkylamine, an alkylamine in which an alkyl group has 6 to 18 carbon atoms or a salt thereof is preferably at least one selected from the group consisting of hexylamine, octadecylamine, dodecylamine, tetradecylamine, and octylamine because it is easy to adjust the contact angle within the above range.

The pH of the surface treatment agent is not particularly limited, but for example, is 4.0 or more and 13 or less, 4.0 or more and 11.5 or less, or 4.0 or more and 10 or less. A case where the surface treatment agent has pH within the above range is preferable because it is easy to adjust the contact angle within the above range.

An optimum pH of the surface treatment agent can be appropriately selected depending on the type of alkylamine compound and the type of solder resist for forming a film. For example, when the alkylamine contained in the surface treatment agent is dodecylamine or tetradecylamine, the pH is preferably 4.0 or more and 10 or less, and when the alkylamine contained in the surface treatment agent is octylamine, the pH is preferably 10.0 or more and 13.0 or less.

As a means for adjusting the pH of the surface treatment agent, the pH can be adjusted by blending the above alkylamine compounds and another known pH adjusting agent.

The pH adjusting agent is not particularly limited. However, examples thereof include an agent used for pH adjustment, such as hydrochloric acid, sulfuric acid, acetic acid, sodium hydroxide, ammonia, ethanolamine, salts thereof (for example, sodium acetate), a general buffer such as an acetate buffer, a phosphate buffer, a citrate buffer, a citrate phosphate buffer, a borate buffer, or a Good's buffer, a chelating agent, or an amino acid.

The surface treatment agent may contain another optional component such as an antifoaming agent, a rust inhibitor, or a solvent in addition to the above components.

The surface treatment agent is preferably a solution in which the above active components and another component are dissolved in water or another known solvent.

A known means can be used as a means for performing a treatment in the surface treatment step of the present embodiment.

For example, a means for bringing a surface treatment agent into contact with the metal substrate surface is not particularly limited, and examples thereof include a surface treatment means using a known liquid agent, such as immersion or spraying.

The temperature of the surface treatment agent is not particularly limited, and is, for example, 20°C or higher and 40°C or lower, and preferably 25°C or higher and 35°C or lower.

Furthermore, the time for performing a treatment with the surface treatment agent (contact time between the surface treatment agent and the metal substrate) is not particularly limited, and is, for example, 10 seconds or more and two minutes or less, and preferably 30 seconds or more and one minute or less.

### <Film forming step>

The manufacturing method of the present embodiment includes a film forming step of forming a film of a resin composition on a surface-treated metal substrate surface by an inkjet method.

Examples of the resin composition used in the film forming step of the present embodiment include an etching resist ink and a solder resist ink.

The etching resist ink and the solder resist ink can be appropriately selected from known ones to be used, and are preferably ones each having a viscosity adjusted to such a degree that ink can be applied by an inkjet method.

For example, the etching resist ink is desirably a resin composition that is cured by an ultraviolet ray after application and can be peeled off with an alkali aqueous solution. Specific examples thereof include a resin composition containing a carboxyl group-containing monomer, a monofunctional monomer, a polyfunctional monomer, a photopolymerization initiator, and another optional component.

The solder resist ink is preferably a resin composition that can be cured by heat or an ultraviolet ray and has heat resistance after curing. Specific examples thereof include a resin composition containing a curing agent such as an epoxy compound or an isocyanate compound and various optional components in addition to the combination of various monomers used in the etching resist ink.

In the film forming step, a resin composition is drawn according to a desired pattern on the metal substrate surface that has been subjected to the etching treatment and the surface treatment using a known inkjet device. For example, the manufacturing method of the present embodiment can be applied to a case where a solder resist is applied to the outermost layer of a printed wiring board, or a case where an etching resist or a plating resist is applied to an inner layer.

In the manufacturing method of the present embodiment, another treatment step may be further performed after the film forming step. For example, after a solder resist film is formed in the film forming step, a plating step of plating a metal surface exposed from an opening of the solder resist may be performed.

In this case, by performing the etching step and the surface treatment step as described above, adhesion of a resin composition such as a solder resist is improved, and penetration of a plating liquid can be suppressed.

In the manufacturing method of the present embodiment, a known treatment step such as a washing step or a drying step may be performed before or after the etching step, the surface treatment step, or the film forming step, or between the steps.

According to the manufacturing method of the present embodiment, the adhesion between the resin composition and the metal substrate surface can be sufficiently improved by performing the etching step, and simultaneously, it is possible to suppress easy occurrence of bleeding due to roughening of the metal substrate surface after the etching step by performing the surface treatment step. Therefore, it is possible to sufficiently improve both the bleeding of the resin composition and the adhesion between the resin composition and the metal substrate surface.

### (Second embodiment: method for manufacturing film-forming substrate)

A method for manufacturing a film-forming substrate according to another present embodiment includes: an etching step of etching a metal substrate surface with a microetching agent; a surface treatment step of bringing the etched metal substrate surface into contact with a surface treatment agent to perform a surface treatment such that a contact angle of a solder resist on the metal substrate surface is 10° or more and 120° or less; and a film forming step of forming a film of a resin composition on the surface-treated metal substrate surface by an inkjet method.

The present embodiment is similar to the first embodiment except that in the surface treatment step, the treatment is performed using a surface treatment agent that can adjust a contact angle on the microetched metal substrate surface such that a contact angle of a solder resist on the metal substrate surface is 10° or more and 120° or less by bringing the surface treatment agent in contact with the metal substrate surface.

The contact angle of a solder resist is, for example, 10° or more and 120° or less, 10° or more and 90° or less, or 10° or more and 80° or less.

The contact angle of a solder resist within the above range easily suppresses bleeding while maintaining the adhesion without inhibiting applicability of the solder resist.

Note that the contact angle in the present embodiment refers to a value measured by changing distilled water in a sessile drop method described in JIS R3257 "Testing method of wettability of glass substrate" to a solder resist. Specifically, the contact angle refers to a value measured by a method indicated in Examples described later.

### (Third embodiment: method for manufacturing film-forming substrate)

A method for manufacturing a film-forming substrate according to another present embodiment includes: a roughening step of mechanically roughening a metal substrate surface; a surface treatment step of bringing the roughened metal substrate surface into contact with a surface treatment agent to perform a surface treatment such that a contact angle of water on the metal substrate surface is 50° or more and 150° or less; and a film forming step of forming a film of a resin composition on the surface-treated metal substrate surface by an inkjet method.

### <Roughening step>

The present embodiment is similar to the first embodiment except that a roughening step is performed instead of the etching step in the manufacturing method of the first embodiment.

In the roughening step, fine unevenness (roughened shape) is formed on a metal substrate surface by a mechanical means to improve the adhesion between the metal substrate surface and the solder resist.

The means for mechanically roughening the metal substrate surface is not particularly limited as long as being able to form unevenness on a metal surface. However, examples thereof include a known means for shaving a metal surface to form unevenness, such as buffing, jet scrubbing, sand blasting, or a belt sander.

In the roughening step, roughening time, the degree of roughening (surface roughness), and the like can be appropriately adjusted such that a metal surface having the above contact angle can be obtained after the surface treatment step performed later.

### (Fourth embodiment: method for manufacturing film-forming substrate)

A method for manufacturing a film-forming substrate having a film of a resin composition formed on a metal substrate surface according to the present embodiment includes: a roughening step of mechanically roughening a metal substrate surface; a surface treatment step of bringing the roughened metal substrate surface into contact with a surface treatment agent to perform a surface treatment such that a contact angle of a solder resist on the metal substrate surface is 10° or more and 120° or less; and a film forming step of forming a film of a resin composition on the surface-treated metal substrate surface by an inkjet method.

The present embodiment is similar to the second embodiment except that a roughening step as in the third embodiment is performed instead of the etching step in the manufacturing method of the second embodiment.

Note that in the manufacturing methods of the first to fourth embodiments, before or after any one of the roughening step and the etching step, the other step may be performed.

### (Fifth embodiment: surface treatment agent)

Next, a surface treatment agent of the present embodiment will be described. The surface treatment agent of the present embodiment is not limited to being used as a surface treatment agent of the above-described manufacturing method of the present embodiment, but an effect can be further enhanced by using the surface treatment agent for the manufacturing method of the present embodiment.

The surface treatment agent of the present embodiment contains at least one selected from the group consisting of alkylamines in each of which an alkyl group has 6 to 18 carbon atoms (hereinafter, also simply referred to as alkylamines) and salts thereof as described above in an amount of 0.001% by mass or more and 1% by mass or less.

Examples of the alkylamines and salts thereof include the above-described alkylamine compounds such as alkylamine organic acid salts and alkylamine inorganic acid salts.

These alkylamines and salts thereof may be used singly or in combination of two or more types thereof.

As described above, as the alkylamine, the alkylamine in which an alkyl group has 6 to 18 carbon atoms or a salt thereof is preferably at least one selected from the group consisting of hexylamine, octadecylamine, dodecylamine, tetradecylamine, and octylamine because it is easy to adjust the contact angle within the above range.

The pH of the surface treatment agent of the present embodiment is not particularly limited, but for example, is 4.0 or more and 13 or less, 4.0 or more and 11.5 or less, or 4.0 or more and 10.0 or less. A case where the surface treatment agent has pH within the above range is preferable because it is easy to adjust the contact angle within the above range.

An optimum pH of the surface treatment agent can be appropriately selected depending on the type of alkylamine compound and the type of solder resist for forming a film. For example, when the alkylamine contained in the surface treatment agent is dodecylamine, tetradecylamine, or octadecylamine, the pH is preferably 4.0 or more and 10.0 or less, and when the alkylamine contained in the surface treatment agent is octylamine or hexylamine, the pH is preferably 10.0 or more and 13.0 or less.

The content of the alkylamine and a salt thereof in the surface treatment agent is 0.001% by mass or more and 1% by mass or less, and preferably 0.01% by mass or more and 1% by mass or less.

The content within such a range can suppress bleeding when a resin composition is applied onto a metal surface by an inkjet method.

Particularly, when the metal substrate surface is etched so as to have the surface roughness (Ra) as described above, by performing the surface treatment with the surface treatment agent of the present embodiment, bleeding is further suppressed, and the adhesion between the resin composition and the metal substrate surface can be further improved.

The surface treatment agent of the present embodiment may contain another optional component such as an antifoaming agent, a rust inhibitor, or a solvent in addition to the alkylamine and a salt thereof.

The surface treatment agent of the present embodiment is preferably a solution in which the alkylamine and a salt thereof and another component are dissolved in water or another known solvent.

### (Sixth embodiment: film-forming substrate)

Next, a film-forming substrate of the present embodiment will be described. The film-forming substrate of the present embodiment is not limited to being manufactured by the above-described method for manufacturing a film-forming substrate according to the present embodiment or/and by using the surface treatment agent of the present embodiment, but can also be manufactured by the manufacturing method of the present embodiment or/and by using the surface treatment agent of the present embodiment.

The film-forming substrate of the present embodiment is a film-forming substrate having a film of a resin composition formed on a metal substrate surface, in which a contact angle of water on the metal substrate surface is 50° or more and 150° or less, and a surface roughness (Ra) thereof is 0.1 µm or more and 0.8 µm or less.

The film-forming substrate of the present embodiment can suppress bleeding of a resin composition and has high adhesion between the resin composition and the metal substrate surface.

The film-forming substrate of the present embodiment can be used as a printed wiring board or the like in which a solder resist film as a resin composition is formed between metal conductors as a metal substrate. In addition, for example, the film-forming substrate of the present embodiment can be used for various electronic/electric devices, medical devices, devices mounted on vehicles, parts for automobiles, and parts for marine devices.

### (Seventh embodiment: film-forming substrate)

A film-forming substrate according to another present embodiment has a film of a resin composition formed on a metal substrate surface, in which a contact angle of a solder resist on the metal substrate surface is 10° or more and 120° or less, and a surface roughness (Ra) thereof is 0.2 µm or more and 0.8 µm or less.

The film-forming substrate of the present embodiment is similar to the sixth embodiment except that a contact angle of a solder resist on the metal substrate surface is 10° or more and 120° or less.

The contact angle of a solder resist is, for example, 10° or more and 120° or less, 10° or more and 90° or less, or 10° or more and 80° or less.

The contact angle of a solder resist within the above range easily suppresses bleeding while maintaining the adhesion without inhibiting applicability of the solder resist.

The method for manufacturing a film-forming substrate, the film-forming substrate, and the surface treatment agent according to the present embodiments are as described above. It should be considered that the embodiments disclosed herein are illustrative and not restrictive in all respects. The scope of the present invention is defined not by the above description but by the claims, and intends to include meaning equivalent to the claims and any modifications within the claims. Examples

Next, Examples of the present invention will be described together with Comparative Examples. Note that the present invention is not construed as being limited to the following Examples.

### "Test 1"

### <Manufacture of test substrate>

A plating plate having a copper plating layer with a thickness of 35 µm (manufactured by AIKOKIKI MFG. Co., Ltd.: 12 cm × 12 cm) was prepared as a test substrate. Next, an organic acid-based microetching agent (manufactured by MEC COMPANY., LTD., CZ series) was sprayed on one surface of the test substrate at a temperature of 25°C at a spray pressure of 0.1 MPa. Etching was performed by adjusting etching time such that the etching amount was 1.0 µm on one surface of the test substrate. Next, the resulting test substrate was washed with water, and the etched surface was immersed in each of the alkylamine aqueous solutions described in Table 1 (temperature: 25°C, concentration: 0.1% by mass) for the time described in Table 1, then washed with water, and dried to obtain a sample of each of Examples 1 to 15.

As Comparative Example 1, a sample was prepared by performing etching and then a hydrochloric acid treatment (immersion in 3.5% hydrochloric acid at 25°C for 10 seconds). As Comparative Example 2, a sample was prepared by performing the hydrochloric acid treatment without performing the etching treatment.

### <Measurement of contact angle>

A contact angle of water on each of the test substrates was measured by a sessile drop method described in JIS R3257 "Testing method of wettability of glass substrate". As a measuring device, an automatic contact angle meter DM-501 manufactured by Kyowa Interface Chemical Co., Ltd. was used.

### <Measurement of bleeding>

A solder resist (manufactured by Taiyo Ink Co., Ltd., product number IJSR-4000) as a resin composition was applied to the entire surface on one side of each of the test substrates to be temporarily cured. Furthermore, after the application, the solder resist was mainly cured. An end of the solder resist of each of the test substrates after curing was observed using a digital microscope (VHX-2000, manufactured by KEYENCE CORPORATION), and a portion having the largest bleeding width was measured.

### <Peel strength>

Next, an initial value of peel strength (N/mm) between the solder resist layer of each of the test substrates and the copper plating layer of the plating plate and a value after 50 hours under HAST conditions (130°C, 85% RH) were measured.

The peel strength was measured according to the measuring method of "peeling strength" described in JIS C6481 (unit in Tables is "N/mm").

### <Surface roughness>

Before a resin composition is applied, a surface roughness of each of the test substrates was measured. The surface roughness was measured using a laser microscope: OLS1100 (manufactured by OLYMPUS) under measurement conditions of image processing averaging: once, surface roughness: 200 times (setting in laser microscope), and a range of visual field: 64.0 µm × 48.0 µm.

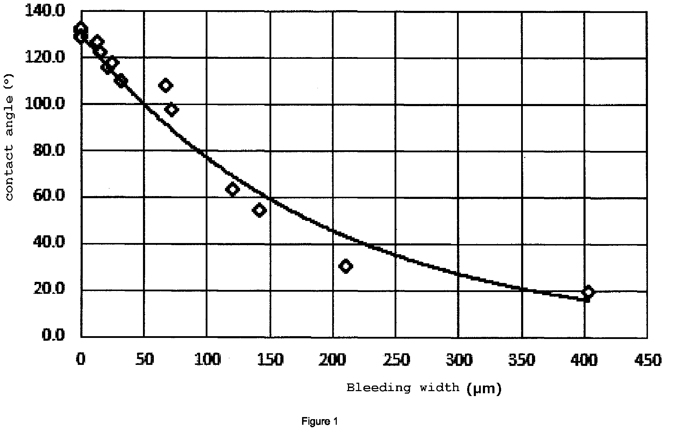

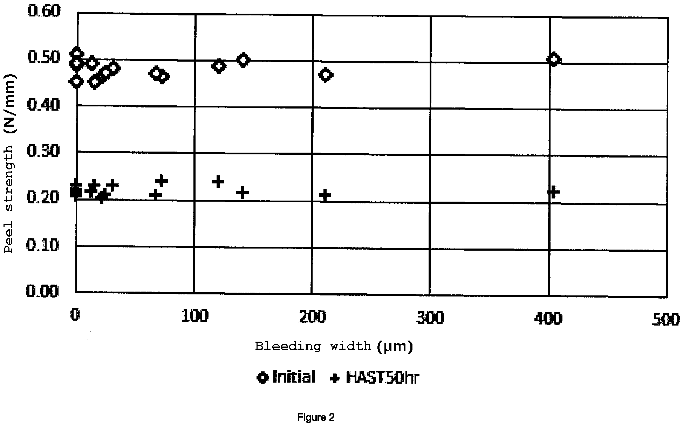

Results are indicated in Table 1 and Figs. 1 and 2.

**[Table 1]**

| | Etching treatment | | Surface roughness | Chemical treatment | Treatment time | Bleeding width µm | Contact angle (°) | Peel strength | |
|---|---|---|---|---|---|---|---|---|---|
| | Chemical agent | Eg amount | Ra | Chemical agent | | | | Initial | HAST 50 hr |
| Example 1 | | | | 0.1% by mass aqueous solution of hexylamine | 10 sec | 210 | 30.2 | 0.47 | 0.21 |
| Example 2 | | | | | 30 sec | 141 | 54.4 | 0.50 | 0.22 |
| Example 3 | | | | | 60 sec | 120 | 63.8 | 0.49 | 0.24 |
| Example 4 | | | | 0.1% by mass aqueous solution of octylamine | 10 sec | 72 | 98.0 | 0.46 | 0.24 |
| Example 5 | | | | | 30 sec | 31 | 110.1 | 0.48 | 0.23 |
| Example 6 | | | | | 60 sec | 12 | 127.0 | 0.49 | 0.22 |
| Example 7 | | | | 0.1% by mass aqueous solution of dodecylamine | 10 sec | 67 | 108.0 | 0.47 | 0.21 |
| Example 8 | | | | | 30 sec | 15 | 122.1 | 0.45 | 0.23 |
| Example 9 | CZ | 1.0 | 0.33 | | 60 sec | 0 | 131.3 | 0.49 | 0.21 |
| Example 10 | | | | 0.1% by mass aqueous solution of tetradecylamine | 10 sec | 21 | 115.7 | 0.46 | 0.20 |
| Example 11 | | | | | 30 sec | 0 | 129.8 | 0.51 | 0.22 |
| Example 12 | | | | | 60 sec | 0 | 133.1 | 0.49 | 0.21 |
| Example 13 | | | | 0.1% by mass aqueous solution of octadecylamine | 10 sec | 24 | 118.0 | 0.47 | 0.21 |
| Example 14 | | | | | 30 sec | 0 | 129.5 | 0.45 | 0.23 |
| Example 15 | | | | | 60 sec | 0 | 128.6 | 0.49 | 0.21 |
| Comparative Example 1 | | | | None | - | 403 | 19.5 | 0.51 | 0.23 |
| Comparative Example 2 | Only washed with acid | - | 0.09 | None | - | No Data | 24.5 | 0.01 | 0.01 |

As indicated in Table 1, the bleeding width was smaller in each of Examples than in Comparative Example 1. Meanwhile, the peel strength was higher in each of Examples than in Comparative Example 2 in which only an acid treatment was performed.

That is, in each of Examples, good results were obtained in both bleeding and peel strength.

### "Test 2"

A relationship between the surface roughness and the peel strength was measured by changing the various alkylamine aqueous solutions and the etching amount used in Test 1.

A plated plate having a copper plating layer with a thickness of 35 µm (manufactured by AIKOKIKI MFG. Co.: 12 cm × 12 cm) was etched by organic acid-based microetchant. The etching amount is indicated in Table 2. The surface roughness of the etched surface was measured by a similar method to Test 1.

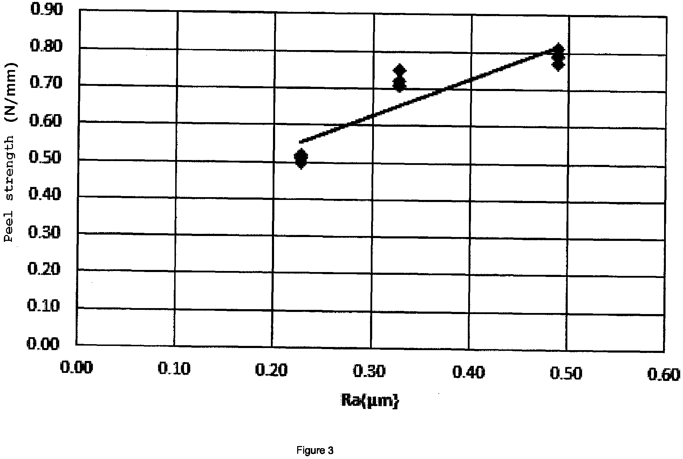

Thereafter, a dip treatment was performed with various alkylamine aqueous solutions. Furthermore, a solder resist (manufactured by Hitachi Chemical Co., Ltd., SR-7300G) as a resin composition was applied to the entire surface on one side of each test substrate to be temporarily cured. Furthermore, after the application, the solder resist was mainly cured, and a peel strength of the resulting product was measured by a similar method to Test 1. Results are indicated in Table 2 and Fig. 3.

**[Table 2]**

| Etching treatment | Etching amount (µm) | Ra (µm) | Surface treatment (60 seconds at room temperature) | Peel strength (N/mm) |
|---|---|---|---|---|
| cz | 0.5 | 0.23 | 0.1% aqueous solution of octylamine | 0.52 |
| | | | 0.1% aqueous solution of dodecylamine | 0.51 |
| | | | 0.1% aqueous solution of tetradecylamine | 0.52 |
| | | | 0.1% aqueous solution of octadecylamine | 0.50 |
| | 1.0 | 0.33 | 0.1% aqueous solution of octylamine | 0.72 |
| | | | 0.1% aqueous solution of dodecylamine | 0.71 |
| | | | 0.1% aqueous solution of tetradecylamine | 0.71 |
| | | | 0.1% aqueous solution of octadecylamine | 0.75 |
| | 1.5 | 0.49 | 0.1% aqueous solution of octylamine | 0.77 |
| | | | 0.1% aqueous solution of dodecylamine | 0.81 |
| | | | 0.1% aqueous solution of tetradecylamine | 0.79 |
| | | | 0.1% aqueous solution of octadecylamine | 0.81 |

As indicated in Table 2, the peel strength was good in each of the test substrates subjected to the surface treatment with the surface roughness within a predetermined range.

"Test 3"

A relationship between the concentration of octylamine and immersion time used in Test 1, and a contact angle was measured as a reference test.

The test substrate used in Test 1 was subjected to a surface treatment at the concentrations and immersion times indicated in Table 3. The treatment was performed under the same conditions as in Test 1.

A contact angle on each of the test substrates was measured in a similar manner to Test 1. Results are indicated in Table 3.

**[Table 3]**

| Immersion time | Octylamine blending concentration (%) | | | | | |
|---|---|---|---|---|---|---|
| | 0.001 | 0.01 | 0.05 | 0.1 | 0.5 | 1 |
| | Contact angle (°) | | | | | |
| 10 sec | 37 | 68 | 98 | 98 | 98 | 98 |
| 30 sec | 49 | 56 | 99 | 110 | 112 | 109 |
| 60 sec | 57 | 120 | 129 | 127 | 130 | 128 |

### "Test 4"

In each of Examples and Comparative Examples similar to Test 1, measurement of a contact angle with respect to a solder resist was added. As a solder resist, in addition to the solder resist used in Test 1 (described as solder resist A in Tables), a solder resist B (manufactured by Tamura Seisakusho Co., Ltd. solder resist for inkjet) was used.

### <Measurement of contact angle>

A contact angle on each of the test substrates with respect to each of the solder resists was measured by a sessile drop method described in JIS R3257 "Testing method of wettability of glass substrate". As a measuring device, an automatic contact angle meter DM-501 manufactured by Kyowa Interface Chemical Co., Ltd. was used.

### <Measurement of pH>

The pH of the surface treatment agent used in each of Examples and Comparative Examples was measured using a desktop pH meter F-72 manufactured by Horiba, Ltd.

Bleeding and peel strength were measured in a similar manner to the Test 1. Results are indicated in Table 4.

**[Table 4]**

| | Name of chemical agent | pH | Treatment time | Bleeding width (A) µm | Bleeding width (B) µm | Contact angle (°) | | | Peel strength (A) N/mm | | Peel strength (B) N/mm | |
|---|---|---|---|---|---|---|---|---|---|---|---|---|
| | | | | | | DIW | Inkjet solder resist | | | | | |
| | | | | | | | A | B | Initial | HAST 50 h | Initial | HAST 50 h |
| Example 16 | 0.1 wt% aqueous solution of hexylamine | 11.2 | 10 s | 210 | 223 | 30.2 | 11.4 | 10.7 | 0.47 | 0.21 | 0.23 | 0.21 |
| Example 17 | | | 30 s | 141 | 145 | 54.4 | 12.3 | 11 | 0. 5 | 0.22 | 0.25 | 0.23 |
| Example 18 | | | 60 s | 120 | 129 | 63.8 | 12.8 | 11.3 | 0.49 | 0.24 | 0.22 | 0.20 |
| Example 19 | 0.1 wt% aqueous solution of octylamine | 11.0 | 10 s | 72 | 69 | 98 | 14 | 14.2 | 0.46 | 0.24 | 0.23 | 0.22 |
| Example 20 | | | 30 s | 31 | 30 | 110.1 | 15.1 | 15.6 | 0.48 | 0.23 | 0.25 | 0.21 |
| Example 21 | | | 60 s | 12 | 11 | 127 | 40.2 | 42.2 | 0.49 | 0.22 | 0.24 | 0.19 |
| Example 22 | 0.1 wt% aqueous solution of dodecylamine | 9. 9 | 10 s | 67 | 55 | 108 | 14.7 | 15.7 | 0.47 | 0.21 | 0.25 | 0.23 |
| Example 23 | | | 30 s | 15 | 17 | 122.1 | 28.5 | 27.2 | 0.45 | 0.23 | 0.24 | 0.20 |
| Example 24 | | | 60 s | 0 | 0 | 131.3 | 65.6 | 70.2 | 0.49 | 0.21 | 0.23 | 0.19 |
| Example 25 | 0.1 wt% aqueous solution of tetradecylamine | 8.3 | 10 s | 21 | 23 | 115.7 | 24.5 | 24.8 | 0.46 | 0.2 | 0.23 | 0.22 |
| Example 26 | | | 30 s | 0 | 0 | 129.8 | 57.4 | 60.1 | 0.51 | 0.22 | 0.25 | 0.23 |
| Example 27 | | | 60 s | 0 | 0 | 133.1 | 71.3 | 79.4 | 0.49 | 0.21 | 0.22 | 0.19 |
| Example 28 | 0.1 wt% aqueous solution of octadecylamine | 7.4 | 10 s | 24 | 28 | 118 | 26.8 | 25.5 | 0.47 | 0.21 | 0.23 | 0.22 |
| Example 29 | | | 30 s | 0 | 0 | 129.5 | 57.3 | 60.6 | 0.45 | 0.23 | 0.24 | 0.20 |
| Example 30 | | | 60 s | 0 | 0 | 128.6 | 56.7 | 59.9 | 0.49 | 0.21 | 0.24 | 0.23 |
| Comparative Example 3 | Only CZ | - | - | 403 | 417 | 19.5 | 9. 8 | 8.8 | 0.51 | 0.23 | 0.25 | 0.23 |
| Comparative Example 4 | Only washed with acid | - | - | - | - | 24.5 | 11 | 9.2 | 0.01 | 0.01 | 0.01 | 0.01 |

As indicated in Table 4, in each of Examples, good results were obtained in both bleeding and peel strength for solder resists A and B.

### "Test 5"

### <Relationship between pH and contact angle>

Each contact angle was measured when the test substrate used in Test 1 was subjected to a surface treatment with pH-adjusted surface treatment agent using dodecylamine, tetradecylamine, or octylamine. The contact angle indicates a contact angle with respect to water or a contact angle with respect to solder resist A or B. The measurement was performed by the methods described in Tests 1 and 4. Results are indicated in Tables 5 to 7. Note that the unit of a numerical value in Tables is "°".

Surface treatment liquids are as follows.

Surface treatment liquid A: 0.1% by mass aqueous solution of dodecylamine

Surface treatment liquid B: 0.1% by mass aqueous solution of tetradecylamine

Surface treatment liquid C: 0.1% by mass aqueous solution of octylamine

The pH was adjusted using hydrochloric acid and sodium hydroxide such that the pH reached a value indicated in each of Tables.

Treatment time was 60 seconds.

**[Table 5]**

| pH | Water | Inkjet solder resist | |
|---|---|---|---|
| | | A | B |
| 2 | 44.7 | 12.7 | 11 |
| 3 | 74.9 | 13.4 | 12.4 |
| 4 | 95.3 | 18.6 | 18.7 |
| 5 | 130.8 | 62.7 | 71 |
| 6 | 135.3 | 67.4 | 69.9 |
| 7 | 134.9 | 67.5 | 69.9 |
| 8 | 133.6 | 65.5 | 70.7 |
| 9 | 135.3 | 71.8 | 76.5 |
| 10 | 134.2 | 52.2 | 57.6 |
| 11 | 120.8 | 36.1 | 36.9 |
| 12 | 115.6 | 22.5 | 29.5 |

Surface treatment liquid A: 0.1% by mass aqueous solution of dodecylamine

**[Table 6]**

| pH | Water | Inkjet solder resist | |
|---|---|---|---|
| | | A | B |
| 2 | 89.8 | 16.9 | 17.7 |
| 3 | 115.8 | 22.9 | 23.7 |
| 4 | 128.4 | 57.7 | 60.6 |
| 5 | 133.6 | 70.3 | 75.8 |
| 6 | 135.6 | 71.3 | 78.7 |
| 7 | 135.3 | 71.6 | 79.1 |
| 8 | 135.6 | 73.2 | 80.2 |
| 9 | 117.6 | 23.5 | 24.5 |
| 10 | 99.7 | 16.4 | 16.9 |
| 11 | 68.2 | 14.4 | 13.8 |
| 12 | 31 | 12.8 | 11.9 |

Surface treatment liquid B: 0.1% by mass aqueous solution of tetradecylamine

**[Table 7]**

| pH | Water | Inkjet solder resist | |
|---|---|---|---|
| | | A | B |
| 2 | 34.5 | 11.1 | 10.4 |
| 3 | 43.3 | 11.6 | 10.4 |
| 4 | 53.8 | 12.6 | 11 |
| 5 | 63.1 | 12.8 | 11.2 |
| 6 | 69.6 | 13.5 | 13.2 |
| 7 | 76.9 | 15.6 | 15.3 |
| 8 | 84.3 | 15.5 | 15.5 |
| 9 | 96.3 | 15.8 | 16.1 |
| 10 | 125.6 | 35.3 | 35.7 |
| 11 | 126.6 | 37.5 | 39.6 |
| 12 | 129.2 | 50.5 | 57.9 |

Surface treatment liquid C: 0.1% by mass aqueous solution of octylamine

## Claims

1. A method for manufacturing a film-forming substrate having a film of a resin composition formed on a metal substrate surface, the method comprising:
an etching step of etching a metal substrate surface with a microetching agent;
a surface treatment step of bringing the etched metal substrate surface into contact with a surface treatment agent to perform a surface treatment such that a contact angle of water on the metal substrate surface is 50° or more and 150° or less; and
a film forming step of forming a film of a resin composition on the surface-treated metal substrate surface by an inkjet method.

2. A method for manufacturing a film-forming substrate having a film of a resin composition formed on a metal substrate surface, the method comprising:
an etching step of etching a metal substrate surface with a microetching agent;
a surface treatment step of bringing the etched metal substrate surface into contact with a surface treatment agent to perform a surface treatment such that a contact angle of a solder resist on the metal substrate is 10° or more and 120° or less; and
a film forming step of forming a film of a resin composition on the surface-treated metal substrate surface by an inkjet method.

3. The method for manufacturing a film-forming substrate according to claim 1 or 2, wherein in the etching step, the metal substrate surface is etched so as to have a surface roughness (Ra) of 0.1 µm or more and 0.8 µm or less.

4. A method for manufacturing a film-forming substrate having a film of a resin composition formed on a metal substrate surface, the method comprising:
a roughening step of mechanically roughening a metal substrate surface;
a surface treatment step of bringing the roughened metal substrate surface into contact with a surface treatment agent to perform a surface treatment such that a contact angle of water on the metal substrate surface is 50° or more and 150° or less; and
a film forming step of forming a film of a resin composition on the surface-treated metal substrate surface by an inkjet method.

5. A method for manufacturing a film-forming substrate having a film of a resin composition formed on a metal substrate surface, the method comprising:
a roughening step of mechanically roughening a metal substrate surface;
a surface treatment step of bringing the roughened metal substrate surface into contact with a surface treatment agent to perform a surface treatment such that a contact angle of a solder resist on the metal substrate is 10° or more and 120° or less; and
a film forming step of forming a film of a resin composition on the surface-treated metal substrate surface by an inkjet method.

6. The method for manufacturing a film-forming substrate according to any one of claims 1 to 5, wherein in the surface treatment step, a surface treatment agent containing at least one selected from the group consisting of alkylamines in each of which an alkyl group has 6 to 18 carbon atoms and salts thereof in an amount of 0.001% by mass or more and 1% by mass or less is brought into contact.

7. The method for manufacturing a film-forming substrate according to claim 6, wherein the alkylamine in which an alkyl group has 6 to 18 carbon atoms or a salt thereof is at least one selected from the group consisting of hexylamine, octadecylamine, dodecylamine, tetradecylamine, and octylamine.

8. The method for manufacturing a film-forming substrate according to any one of claims 1 to 7, wherein the surface treatment agent has pH of 4.0 or more and 11.5 or less.

9. A film-forming substrate having a film of a resin composition formed on a metal substrate surface, wherein a contact angle of water on the metal substrate surfaces is 50° or more and 150° or less, and a surface roughness (Ra) thereof is 0.1 µm or more and 0.8 µm or less.

10. A film-forming substrate having a film of a resin composition formed on a metal substrate surface, wherein a contact angle of a solder resist on the metal substrate surfaces is 10° or more and 120° or less, and a surface roughness (Ra) thereof is 0.1 µm or more and 0.8 µm or less.

11. A surface treatment agent for treating a metal substrate surface, comprising at least one selected from the group consisting of alkylamines in each of which an alkyl group has 6 to 18 carbon atoms and salts thereof in an amount of 0.001% by mass or more and 1% by mass or less.

12. The surface treatment agent according to claim 11, wherein the alkylamine in which an alkyl group has 6 to 18 carbon atoms or a salt thereof is at least one selected from the group consisting of hexylamine, octadecylamine, dodecylamine, tetradecylamine, and octylamine.

13. The surface treatment agent according to claim 11 or 12, having pH of 4.0 or more and 11.5 or less.
